Europäisches Patentamt

European Patent Office

Office européen des brevets

(19)

(11) **EP 0 865 012 A2**

(12) **EUROPÄISCHE PATENTANMELDUNG**

(43) Veröffentlichungstag:
**16.09.1998 Patentblatt 1998/38**

(51) Int. Cl.$^6$: **G08B 13/183**

(21) Anmeldenummer: **98104107.2**

(22) Anmeldetag: **07.03.1998**

(84) Benannte Vertragsstaaten:
**AT BE CH DE DK ES FI FR GB GR IE IT LI LU MC NL PT**
Benannte Erstreckungsstaaten:
**AL LT LV MK RO SI**

(30) Priorität: **10.03.1997 DE 19709805**

(71) Anmelder: **Stribel GmbH**
**72636 Frickenhausen (DE)**

(72) Erfinder: **Görner, Wolfgang**
**74321 Bietigheim-Bissingen (DE)**

(74) Vertreter:
**Hoeger, Stellrecht & Partner**
**Uhlandstrasse 14 c**
**70182 Stuttgart (DE)**

(54) **Raumüberwachungsgerät**

(57)    Um ein Raumüberwachungsgerät umfassend einen Empfänger für elektromagnetische Strahlung und eine ein Beobachtungssignal des Empfängers im Hinblick auf ein Alarmkriterium überprüfende Überwachungsschaltung, zu schaffen welches einerseits in der Lage ist, möglichst zuverlässig Umwelteinflüsse von einem Eindringen in den überwachten Raum zu trennen und andererseits universell einsetzbar ist, wird vorgeschlagen, daß der Empfänger aus einem genau bestimmten Beobachtungsraum, die Intensität der elektromagnetischen Strahlung integral erfaßt und ein der integralen Intensität entsprechendes Beobachtungssignal erzeugt, daß ein Sender vorgesehen ist, der zur Ausleuchtung der Beobachtungsfläche elektromagnetische Strahlung aussendet und daß die Überwachungsschaltung während eines senderaktiven Zeitraums ein senderaktives Beobachtungssignal und während eines senderinaktiven Zeitraums ein senderinaktives Beobachtungssignal erfaßt und sowohl das senderaktive Beobachtungssignal als auch das senderinaktive Beobachtungssignal bei der Entscheidung hinsichtlich der Erfüllung oder Nichterfüllung des Alarmkriteriums berücksichtigt.

**Fig. 1**

**Beschreibung**

Die Erfindung betrifft ein Raumüberwachungsgerät umfassend einen Empfänger für elektromagnetische Strahlungen und eine ein Beobachtungssignal des Empfängers im Hinblick auf ein Alarmkriterium überprüfende Überwachungsschaltung.

Derartige Raumüberwachungsgeräte sind aus dem Stand der Technik bekannt. Bei diesen wird beispielsweise die elektromagnetische Strahlung aus einem unscharf definierten Raumbereich erfaßt und bei Überschreiten einer Intensitätsschwelle als Alarmkriterium ein Signal abgegeben.

Der Nachteil dieser Raumüberwachungsgeräte besteht darin, daß sie in einer Vielzahl von Fällen Fehlalarme geben, die durch eine Vielzahl von Umfeldeinflüssen ausgelöst sind, jedoch nicht durch ein konkretes Eindringen in den überwachten Raum bedingt sind.

Es sind ferner Raumüberwachungsgeräte bekannt, welche mit Ultraschall arbeiten und einen Ultraschallsender und einen Ultraschallempfänger aufweisen, wobei eine Überwachungsschaltung Dopplerverschiebungen des empfangenen Ultraschallsignals auswertet und aufgrund dieser Dopplerverschiebungen auf ein Eindringen in den überwachten Raum schließt.

Derartige Ultraschallgeräte haben den Nachteil, daß sie einen geschlossenen Raum benötigen, um mit hinreichender Zuverlässigkeit ein Eindringen in diesen Raum von Umwelteinflüssen unterscheiden zu können.

Der Erfindung liegt daher die Aufgabe zugrunde, ein Raumüberwachungsgerät zu schaffen, welches einerseits in der Lage ist, möglichst zuverlässig Umwelteinflüsse von einem Eindringen in den überwachten Raum zu trennen und andererseits universell einsetzbar ist, das heißt sowohl zur Überwachung geschlossener als auch offener Räume dienen kann.

Ein derartiges Raumüberwachungsgerät soll insbesondere zum Einsatz in Kraftfahrzeugen geeignet sein und muß damit eine hohe Fehlalarmsicherheit bei sich ständig ändernden Umgebungseinflüssen aufweisen.

Diese Aufgabe wird bei einem Raumüberwachungsgerät der eingangs beschriebenen Art erfindungsgemäß dadurch gelöst, daß der Empfänger aus einem genau bestimmten Beobachtungsraum, definiert durch einen fest vorgegebenen Beobachtungsraumwinkel und eine hinsichtlich ihrer Umrißlinie durch den Beobachtungsraumwinkel bestimmte Beobachtungsfläche, die Intensität der elektromagnetischen Strahlung integral erfaßt und ein der integralen Intensität entsprechendes Beobachtungssignal erzeugt, daß ein Sender vorgesehen ist, der zur Ausleuchtung der Beobachtungsfläche elektromagnetische Strahlung aussendet und daß die Überwachungsschaltung während eines senderaktiven Zeitraums ein senderaktives Beobachtungssignal und während eines senderinaktiven Zeitraums ein senderinaktives Beobachtungssignal erfaßt und sowohl das senderaktive Beobachtungssignal als auch das senderinaktive Beobachtungssignal bei der Entscheidung hinsichtlich der Erfüllung oder Nichterfüllung des Alarmkriteriums berücksichtigt.

Der Vorteil der erfindungsgemäßen Lösung ist darin zu sehen, daß einerseits der Empfänger lediglich die elektromagnetische Strahlung aus einem scharf abgegrenzten Beobachtungsraum integral erfaßt und sich außerdem dieser Beobachtungsraum nahezu beliebig formen und somit variable an die jeweilige Situation anpassen und beispielsweise so gestalten läßt, daß gegebenenfalls störende Umgebungen außerhalb desselben liegen und damit keinerlei Einfluß auf die integral erfaßte elektromagnetische Strahlung haben.

Darüber hinaus wird durch das zusätzliche Vorsehen eines Senders nicht nur die ohne Ausleuchtung der Beobachtungsfläche im Beobachtungsraum empfangene elektromagnetische Strahlung erfaßt, sondern auch die bei definierter Ausleuchtung des Beobachtungsraums mit der Beobachtungsfläche empfangene elektromagnetische Strahlung, so daß der Beobachtungsraum zwei unterschiedlichen Überprüfungen unterzogen wird und aus dem Vergleich dieser beiden unterschiedlichen Überprüfungen erst die Entscheidung über das Alarmkriterium getroffen wird und somit aufgrund der zweifachen unterschiedlichen Prüfung Störeinflüsse eliminiert werden, die bei üblichen Raumüberwachungsgeräten einen Alarm auslösen.

Prinzipiell wäre es denkbar, daß der Sender lediglich Teile des Beobachtungsraums und der Beobachtungsfläche ausleuchtet. Dies hätte jedoch den Nachteil, daß bei integraler Erfassung des Beobachtungsraums und der Beobachtungsfläche über den Empfänger sich ein Eingriff in den Beobachtungsraum unterschiedlich auswirken würde.

Aus diesem Grund ist vorteilhafterweise vorgesehen, daß der Sender die Beobachtungsfläche im wesentlichen voll ausleuchtet und somit der Empfänger - im Fall eines nicht vorliegenden - die von der gesamten Beobachtungsfläche reflektierte, insbesondere diffus reflektierte, elektromagnetische Strahlung des Senders empfängt.

In diesem Fall wäre es ferner möglich, den Sender so auszubilden, daß er in einen weit größeren Raumwinkel abstrahlt, als erforderlich ist, um die Beobachtungsfläche auszuleuchten. Dies hätte jedoch den Nachteil, daß gegebenenfalls Randbereiche um die eigentliche Beobachtungsfläche, die beispielsweise stark elektromagnetische Strahlung reflektieren könnten, angestrahlt würden und somit beispielsweise bei der Bewegung derselben elektromagnetische Strahlung vom Empfänger empfangen würde, die nicht von der Beobachtungsfläche stammt. Dies wäre eine weitere Quelle für einen störenden Umgebungseinfluß.

Aus diesem Grund ist vorzugsweise vorgesehen, daß der Sender in einen derartigen Raumwinkel abstrahlt, daß die abgestrahlte elektromagnetische Strahlung im wesentlichen auf die Beobachtungsfläche begrenzt ist. Damit ist bei der integralen Erfassung der reflektierten elektromagnetischen Strahlung des Senders sichergestellt, daß diese auch nur von dem Beobachtungsraum oder der Beobachtungsfläche stammt und somit durch geeignete Wahl des Beobachtungsraums und der Beobachtungsfläche eine Vielzahl von Umgebungsstörungen bereits ausgeschlossen werden kann.

Prinzipiell ist bei der bislang beschriebenen erfindungsgemäßen Lösung die relative Anordnung von Sender und Empfänger zueinander nicht festgelegt. Beispielsweise wäre es denkbar, Sender und Empfänger im Abstand voneinander anzuordnen.

Besonders günstig ist es jedoch, wenn der Sender die elektromagnetische Strahlung in einen Raumwinkel abstrahlt, welcher überwiegend mit dem Beobachtungsraumwinkel überlappt. Dies hat den großen Vorteil, daß einerseits der Beobachtungsraum im wesentlichen auch von der vom Sender ausgestrahlten elektromagnetischen Strahlung durchsetzt wird und somit ein Eingriff in den Beobachtungsraum dann sowohl den Raumwinkel der elektromagnetischen Strahlung des Senders als auch den Beobachtungsraumwinkel betrifft und somit sich sowohl auf das senderaktive Beobachtungssignal als auch das senderinaktive Beobachtungssignal auswirken kann.

Insbesondere mit Rücksicht auf die Einbauverhältnisse, beispielsweise in einem Kraftfahrzeug, sieht eine besonders günstige Lösung vor, daß der Sender und der Empfänger nebeneinander in einem Gehäuse angeordnet und auf dieselbe Beobachtungsfläche gerichtet sind.

Im Rahmen der erfindungsgemäßen Lösung wurde die Zahl der überwachten Beobachtungsräume nicht festgelegt. So ist es im Rahmen der erfindungsgemäßen Lösung vorgesehen, mindestens einen Beobachtungsraum mit einem erfindungsgemäßen Raumüberwachungsgerät zu überwachen.

Insbesondere beim Einsatz in ein Kraftfahrzeug ist es aufgrund der Tatsache, daß sich die Beobachtungsräume genau bestimmen lassen, vorteilhaft, wenn das Raumüberwachungsgerät mehrere, genau bestimmte Beobachtungsräume überwacht und daß jedem Beobachtungsraum mindestens ein Empfänger zugeordnet ist. Somit besteht beispielsweise bei einem Kraftfahrzeug die Möglichkeit, gezielte, insbesondere einbruchssensible Bereiche desselben zu überwachen und andererseits aber auch die Möglichkeit, gezielt Bereiche von der Überwachung auszunehmen, insbesondere solche, welche Umgebungseinflüssen ausgesetzt sind. Beispielsweise ist es damit möglich, in einem Kraftfahrzeug die Beobachtungsflächen so zu legen, daß sie keine für elektromagnetische Strahlung durchlässigen Flächen, wie beispielsweise Fensterflächen tangieren, so daß die durch Fensterflächen einfallende Strahlung nicht direkt von dem Empfänger empfangen wird und unerwünschte Signalanteile, die insbesondere hinsichtlich ihrer Zeitkonstanz unbestimmbar sind, vermieden werden.

Vorzugsweise ist jedem Beobachtungsraum auch mindestens ein Sender zugeordnet.

Ferner ist es dabei aber auch möglich, die Beobachtungsflächen und den Beobachtungsraumwinkel so anzuordnen, daß von den Beobachtungsflächen reflektierte von außen kommende elektromagnetische Strahlung nicht in den Beobachtungsraumwinkel fällt und somit nicht von dem Empfänger als zusätzlicher Signalanteil miterfaßt wird.

Bei der Überwachung mehrerer Beobachtungsräume wurde bislang nicht näher definiert, wie die Überwachungsschaltung zu den einzelnen Sendern und Empfängern ausgebildet sein soll.

Besonders günstig ist es dabei, wenn eine einzige Überwachungsschaltung die Ermittlung der Alarmkriterien für die einzelnen Beobachtungsräume ermittelt.

Beispielsweise ist es denkbar, bei ausreichender Leistungsfähigkeit der Überwachungsschaltung vorzusehen, daß die Überwachungsschaltung die Alarmkriterien für die einzelnen Beobachtungsräume parallel prüft. Die Überwachungsschaltung läßt sich jedoch besonders einfach dann konzipieren, wenn sie die Alarmkriterien für die einzelnen Beobachtungsräume nacheinander prüft. Dies ist für die meisten Überwachungsfälle ausreichend.

Im Rahmen der bisherigen Erläuterung der erfindungsgemäßen Lösung wurde nicht näher spezifiziert, wie der Beobachtungsraumwinkel des Empfängers definierbar sein soll. Beispielsweise wäre es denkbar, als Empfänger eine für elektromagnetische Strahlung empfindliche Diode vorzusehen, welche bereits aufgrund ihrer Konzeption nur in der Lage ist, elektromagnetische Strahlung aus einem bestimmten Raumwinkel zu detektieren.

Um jedoch die Möglichkeit zu haben, in erfindungsgemäßer Weise den Beobachtungsraumwinkel genau festzulegen, ist vorgesehen, daß dem Empfänger eine auf die elektromagnetische Strahlung wirkende richtungsgebende Optik zugeordnet ist, welche die Möglichkeit schafft, den Beobachtungsraumwinkel nicht nur exakt festzulegen, sondern auch definiert zu formen.

Mit einer derartigen richtungsgebenden Optik besteht die Möglichkeit, auch bei jeweils demselben Empfänger das Raumüberwachungsgerät an unterschiedliche Einsatzzwecke durch Auswechseln oder Einstellung der richtungsgebenden Optik anzupassen.

Die richtungsgebende Optik könnte beispielsweise als separates Element im Abstand vom Empfänger angeordnet sein. Eine aufgrund ihrer Kompaktheit und insbesondere auch definierten einmaligen Einstellbarkeit besonders günstige Lösung sieht jedoch vor, daß die richtungsgebende Optik in dem Gehäuse für den Empfängers angeordnet ist und vorzugsweise auf die elektromagnetische Strahlung vor Auftreffen derselben auf den Empfänger wirkt.

Vorzugsweise ist dabei die richtungsgebende Optik ein separates, nicht in den Empfänger integriertes Bauteil, so daß die richtungsgebende Optik unabhängig vom Empfänger herstellbar ist und derselbe Empfänger mit unterschiedlichen richtungsgebenden Optiken einsetzbar ist.

Um jedoch die Möglichkeit zu haben, in erfindungsgemäßer Weise den Beobachtungsraumwinkel genau festzulegen, ist vorgesehen, daß dem Sender eine auf die elektromagnetische Strahlung wirkende richtungsgebende Optik zugeordnet ist, welche die Möglichkeit schafft, den Raumwinkel nicht nur exakt festzulegen, sondern auch definiert zu formen.

Mit einer derartigen richtungsgebenden Optik besteht die Möglichkeit, auch bei jeweils demselben Sender das Raumüberwachungsgerät an unterschiedliche Einsatzzwecke durch Auswechseln oder Einstellung der richtungsgebenden Optik anzupassen.

Die richtungsgebende Optik könnte beispielsweise als separates Element im Abstand vom Sender angeordnet sein. Eine aufgrund ihrer Kompaktheit und insbesondere auch definierten einmaligen Einstellbarkeit besonders günstige Lösung sieht jedoch vor, daß die richtungsgebende Optik in dem Gehäuse für den Sender angeordnet ist und vorzugsweise auf die vom Sender kommende elektromagnetische Strahlung wirkt.

Vorzugsweise ist dabei die richtungsgebende Optik ein separates, nicht in den Sender integriertes Bauteil, so daß die richtungsgebende Optik unabhängig vom Sender herstellbar ist und derselbe Sender mit unterschiedlichen richtungsgebenden Optiken einsetzbar ist.

Die richtungsgebende Optik kann in unterschiedlichster Art und Weise ausgebildet sein. Im einfachsten Fall ist es denkbar, daß die richtungsgebende Optik lediglich als Blende ausgebildet ist, welche die Möglichkeit schafft, eine Außenkontur des Beobachtungsraumwinkels gezielt zu beeinflussen.

Die Leistungsfähigkeit und auch die Störungssicherheit des erfindungsgemäßen Raumüberwachungsgeräts läßt sich jedoch erheblich verbessern, wenn die richtungsgebende Optik strahlformende Elemente, wie beispielsweise Spiegel oder Linsen umfaßt.

Im Rahmen der bisherigen Erläuterung des erfindungsgemäßen Raumüberwachungsgeräts wurde nicht näher darauf eingegangen, wie die Überwachungsschaltung im einzelnen arbeitet.

So sieht ein vorteilhaftes Ausführungsbeispiel vor, daß die Überwachungsschaltung ständig zwischen senderaktiven und senderinaktiven Zeiträumen wechselt und somit ständig senderaktive und senderinaktive Beobachtungssignale empfängt und zur Ableitung des Zustandskriterium heranziehen kann.

Das Wechseln zwischen senderaktiven und senderinaktiven Zeiträumen erfolgt vorzugsweise mit einer Frequenz größer ungefähr 3 vorzugsweise 6 Hz.

Vorzugsweise ist dabei vorgesehen, daS die senderaktiven und die senderinaktiven Zeiträume in derselben Größenordnung liegen, um bei der Analyse der senderaktiven Beobachtungssignale und der senderinaktiven Beobachtungssignale im wesentlichen in derselben Weise vorgehen zu können.

Im Rahmen der erfindungsgemäßen Lösung wäre es beispielsweise denkbar, die aufeinanderfolgenden senderaktiven Beobachtungssignale und senderinaktiven Beobachtungssignale als ein einziges Beobachtungssignal mit durch den Wechsel zwischen senderaktiven und senderinaktiven Beobachtungssignalen bedingten Frequenzanteilen zu betrachten und dieses Beobachtungssignal daraufhin zu prüfen, ob und inwieweit sich die Frequenzanteile verändern. Beispielsweise würden sich die Frequenzanteile dadurch ändern, daß durch einen Eingriff in den Beobachtungsraum die senderaktiven Beobachtungssignale eine geringere Intensität aufweisen als vor dem Eingriff, so daS ein Alarmkriterium eine Mindeständerung in einem oder mehreren Frequenzanteilen wäre.

Eine störungssicherere und zuverlässigere Auswertung ist dann möglich, wenn die Überwachungsschaltung bei der Auswertung des Alarmkriteriums zwischen senderaktiven Beobachtungssignalen und senderinaktiven Beobachtungssignalen unterscheidet und somit in der Lage ist, diese hinsichtlich des Alarmkriteriums getrennt zu analysieren.

Bei getrennter Betrachtung der senderaktiven und senderinaktiven Beobachtungssignale ist im Rahmen der erfindungsgemäßen Lösung beispielsweise vorgesehen, daß die Überwachungsschaltung ein erstes Alarmkriterium auf das senderaktive und ein zweites Alarmkriterium auf das senderinaktive Beobachtungssignal anwendet und zumindest bei Erfüllung eines Alarmkriteriums einen Alarm auslöst. Somit kann die Betrachtung der senderaktiven Beobachtungssignale völlig unabhängig von der des senderinaktiven Beobachtungssignals erfolgen.

Eine hinsichtlich der Störungsanfälligkeit noch bessere Lösung sieht vor, daß die Überwachungsschaltung bei Anwendung des Alarmkriteriums auf eines der Beobachtungssignale, d.h. auf das senderaktive oder senderinaktive Beobachtungssignal, das jeweils andere Beobachtungssignal ebenfalls berücksichtigt.

Dies ist entweder dadurch möglich, daß die Überwachungsschaltung das Alarmkriterium unter Berücksichtigung des anderen Beobachtungssignals festlegt und dann auf das eine Beobachtungssignal anwendet und/oder dadurch, daß die Überwachungsschaltung das eine der Beobachtungssignale unter Berücksichtigung des anderen Beobachtungssignals modifiziert und dann das entweder vom anderen Beobachtungssignal abhängige oder unabhängige Alarmkriterium auf dieses eine modifizierte Beobachtungssignal anwendet.

Diese Lösung ermöglicht es, Langzeitdrifteffekte sowohl hinsichtlich der empfangenen elektromagnetischen Strahlung als auch hinsichtlich der eingesetzten Bauteile so zu erfassen, daß sie weder einen Alarm auslösen noch die Empfindlichkeit hinsichtlich der zu erkennenden Eingriffe in den Beobachtungsraum wesentlich verändern, d.h. daß sich die Minimalintensität des, für das Auslösen eines Alarms erforderlichen Eingriffs in den Beobachtungsraum nicht wesentlich ändert, obwohl sich beispielsweise die beobachtete Intensität des Beobachtungssignals durch externe Einflüsse, wie Änderung des empfangenen elektromagnetischen Strahlung, beispielsweise durch die ändernde Sonneneinstrahlung und/oder Aufheizung der Beobachtungsfläche, und/oder interne Einflüsse, wie Drifterscheinungen auf Seiten des Empfängers oder elektronischer Bauteile zur Verarbeitung des Beobachtungssignals, beispielsweise aufgrund von Temperaturschwankungen, über längere Zeiträume gesehen ändert.

Eine besonders einfache erfindungsgemäße Lösung sieht vor, daß die Überwachungsschaltung das jeweilige Beobachtungssignal im Hinblick auf ein Überschreiten einer das Alarmkriterium darstellenden Schwelle überprüft, wobei vorzugsweise die Schwelle unter Heranziehung des jeweils anderen Beobachtungssignals ermittelt wurde.

Dabei ist es günstig, bei Ermittlung der Schwelle die zeitliche Entwicklung des jeweils zu prüfenden Beobachtungssignals zu ermitteln, um auch Änderungen desselben, beispielsweise Änderungen in der Leistung des Senders, korrigieren zu können.

Eine besonders zweckmäßige Lösung sieht vor, daß die Überwachungsschaltung bei der Festlegung der Schwelle ein aus den jeweils zu prüfenden Beobachtungssignalen gemitteltes Signal heranzieht.

Ferner ist es vorteilhaft, wenn bei der Festlegung der Schwelle eine Streuung der jeweils zu prüfenden Beobachtungssignale um das gemittelte Beobachtungssignal ermittelt wird. Damit besteht die Möglichkeit den Einfluß systembedingter Streuungen des jeweiligen Beobachtungssignals bei der Anwendung des Alarmkriteriums zu unterdrücken und somit im wesentlichen durch diese ausgelöste Alarme weitgehend zu vermeiden.

Beispielsweise ist dies dadurch möglich, daß die Schwelle außerhalb einer mittleren Streubandbreite des jeweils zu prüfenden Beobachtungssignals gesetzt wird.

Vorzugsweise wird als Streubandbreite die mittlere Standardabweichung berechnet.

Besonders vorteilhaft ist es bei der erfindungsgemäßen Lösung, wenn die Überwachungsschaltung zur Analyse des jeweiligen Beobachtungssignals ein eine Vielzahl von senderaktiven und senderinaktiven Zeiträumen umfassendes Beobachtungszeitfenster heranzieht.

Vorzugsweise ist das Beobachtungszeitfenster dabei so gewählt, daß sich übliche Eingriffe in einen Beobachtungsraum innerhalb einer Zeitspanne abspielen, die kleiner ist als das Beobachtungszeitfenster. Das Beobachtungszeitfenster ist aber andererseits auch so dimensioniert, daß Langzeitdrifteffekte, beispielsweise eine Aufheizung der Beobachtungsfläche oder auch eine Langzeitdrift des Senders längere Zeitkonstanten aufweisen als das Beobachtungszeitfenster, so daß beispielsweise bei Mittelwertbildung innerhalb des Beobachtungszeitfensters der im jeweiligen Beobachtungszeitfenster gebildete Mittelwert sich entsprechend den Langzeitdrifteffekten ändert.

Im Hinblick auf die Alarmschwelle ist vorzugsweise vorgesehen, daß das jeweilige Beobachtungssignal nicht nur hinsichtlich des Überschreitens einer einzigen, beispielsweise einer oberen Alarmschwelle als Alarmkriterium überprüft wird, sondern auch hinsichtlich des Überschreitens einer weiteren, beispielsweise einer unteren Alarmschwelle als weiteres Alarmkriterium, da beispielsweise ein Eingriff in den Beobachtungsraum sowohl zu einer stärkeren Reflexion der vom Sender gesendeten elektromagnetischen Strahlung als auch zu einer schwächeren Reflexion führen kann, je nach dem, wie die oberflächliche Reflektivität des in den Beobachtungsraum eingreifenden Körpers gegenüber der Reflektivität der Beobachtungsfläche selbst ausgebildet ist.

Bei einer erfindungsgemäßen Lösung ist es günstig, wenn die Überwachungsschaltung primär die senderaktiven Beobachtungssignale im Hinblick auf das Überschreiten einer oder mehrerer Schwellen analysiert, wobei bei der Ermittlung der Schwelle das senderinaktive Beobachtungssignal ebenfalls herangezogen wird.

Vorzugsweise wird hierbei eine obere Alarmschwelle und eine untere Alarmschwelle festgelegt und das senderaktive Überwachungssignal im Hinblick auf das Überschreiten oder Unterschreiten der oberen bzw. unteren Alarmschwelle überprüft.

Zur Festlegung der Alarmschwelle wird das senderinaktive Beobachtungssignal berücksichtigt und ferner wird das senderaktive Beobachtungssignal über einen durch das Beobachtungszeitfenster definierten Zeitraum gemittelt und als gemitteltes Signal zur Bestimmung der Schwelle herangezogen.

Alternativ oder ergänzend zu all den bislang beschriebenen Lösungen, bei welchen eine Überprüfung der senderaktiven oder senderinaktiven Beobachtungssignale mittels einer Alarmschwelle erfolgt, wobei sowohl senderaktive als auch senderinaktive Beobachtungssignale eingehen, und somit entsprechend den herangezogenen senderaktiven und senderinaktiven Beobachtungssignalen eine Anpassung der Schwelle an die jeweiligen Umgebungsverhältnisse erfolgt, ist erfindungsgemäß vorgesehen, entweder eine sowohl von senderaktiven als auch senderinaktiven Beobachtungssignalen unabhängige oder eine von diesen abhängige Schwelle heranzuziehen, und dabei die jeweils zur überprüfenden Beobachtungssignale entsprechend dem Langzeitverhalten zu korrigieren.

Hierzu ist es möglich, beispielsweise bei Betrachtung der zu den jeweiligen Zeitpunkten vorliegenden senderaktiven oder senderinaktiven Beobachtungssignale von diesen einen Mittelwert der senderaktiven Beobachtungssignale sowie einen Mittelwert der senderinaktiven Beobachtungssignale zu subtrahieren, wobei die Mittelwerte noch mit einem Gewichtungsfaktor multipliziert werden können. Damit lassen sich beispielsweise Effekte, wie eine stärkere elektromagnetische Strahlung der Beobachtungsfläche aufgrund unterschiedlicher Aufheizung oder auch eine Änderung der in den Beobachtungsraumwinkel hineinreflektierten diffusen Streustrahlung eliminieren, um eine Änderung der zu den jeweiligen Zeitpunkten vorliegenden senderinaktiven oder senderaktiven Beobachtungssignals durch einen tatsächlichen Eingriff in den Beobachtungsraum deutlicher erkennbar zu machen.

Alternativ oder ergänzend zum Ermitteln der Überschreitung einer Alarmschwelle bei dem jeweiligen Beobachtungssignal ist aber im Rahmen der erfindungsgemäßen Lösung ebenfalls vorgesehen, das sich zeitlich entwickelnde jeweilige Beobachtungssignal zu differenzieren und dadurch Änderungen desselben deutlich werden zu lassen.

Das Differenzieren des Beobachtungssignals kann während dem gesamten Zeitraum der Erfassung desselben erfolgen, aber auch nur für ausgewählte Zeitspannen, beispielsweise in den Zeitspannen des Wechselns von senderaktiven zu senderinaktiven Zeiträumen.

Eine besonders vorteilhafte Lösung sieht vor, daß die Überwachungsschaltung das jeweilige sich zeitlich entwickelnde Beobachtungssignal einerseits im Hinblick auf das Überschreiten einer Schwelle hin überprüft und andererseits auch das zeitlich differenzierte Beobachtungssignal im Hinblick auf das Überschreiten einer Schwelle hin überprüft, um nur in dem Fall, daß plötzliche starke Änderungen des jeweiligen Beobachtungssignals auftreten, ein Alarmkriterium als erfüllt anzusehen.

Eine weitere vorteilhafte Lösung sieht vor, daß die Überwachungsschaltung die Dauer der Überschreitung einer Schwelle prüft und erst bei Überschreiten der Schwelle während einer Mindestdauer das Alarmkriterium als erfüllt ansieht.

Ein besonders bevorzugtes Ausführungsbeispiel einer erfindungsgemäßen Lösung sieht vor, daß das vom Empfänger generierte Beobachtungssignal nicht als direktes Intensitätssignal weiterverarbeitet wird, sondern als ein mit der erfaßten Intensität entsprechenden Frequenzen moduliertes Signal auftritt. In diesem Fall ist es besonders einfach, dieses Signal digital zu verarbeiten.

Das Beobachtungssignal könnte beispielsweise ein durch beliebige Modulationsformen frequenzmoduliertes Signal sein.

Besonders vorteilhaft läßt sich jedoch das Beobachtungssignal dann verarbeiten, wenn diese Impulse mit konstantem Pegel, jedoch mit entsprechend der erfaßten Intensität ausgebildeten Pulsweiten aufweist, also ein sogenanntes pulsweitenmoduliertes Signal darstellt.

In diesem Fall ist eine Verarbeitung dieses pulsweitenmodulierten Signals dann besonders günstig, wenn die Überwachungsschaltung die Zeitabstände zwischen wechselnden Flanken des pulsweitenmodulierten Signals erfaßt und diese Zeitabstände als Beobachtungssignal und somit als Maß für die vom Empfänger empfangene Intensität heranzieht.

Bei allen vorstehend beschriebenen Ausführungsbeispielen ist es beispielsweise denkbar, die Analyse des jeweiligen Beobachtungssignals im Hinblick auf die Entscheidung hinsichtlich der Erfüllung oder Nichterfüllung des Alarmkriteriums unmittelbar bei Erfassung des jeweiligen Beobachtungssignals durchzuführen. Das heißt beispielsweise die Prüfung hinsichtlich der Überschreitung eines Schwellwertes oder die Differenzierung oder ähnliche Operationen unmittelbar jeweils bei der Erfassung des jeweiligen Beobachtungssignals durchzuführen. Insoweit als Mittelwerte des jeweiligen Beobachtungssignals herangezogen werden, können die jeweils bis zu der Erfassung des jeweiligen Beobachtungssignals ermittelten Mittelwerte verwendet werden.

Alternativ dazu sieht eine besonders günstige Lösung vor, daß die jeweiligen Beobachtungssignale für einen definierten Zeitraum erfaßt, gespeichert und nachfolgend für diesen Zeitraum die Überprüfung hinsichtlich der Erfüllung oder Nichterfüllung des Alarmkriteriums durchgeführt wird. Das heißt, daß für die gespeicherten Beobachtungssignale Mittelwerte gebildet und die jeweiligen Analyseschritte durchgeführt werden. Als Zeitraum wird beispielsweise der Zeitraum des Beobachtungsfensters herangezogen. Diese Lösung hat den Vorteil, daß sie einerseits erlaubt, die beispielsweise zeitaufwendigen Analysen in einem Rechner nach Erfassung der jeweiligen Beobachtungssignale ablaufen zu lassen, wobei beispielsweise oder zeitversetzt dazu die Möglichkeit besteht, neue Beobachtungssignale zu erfassen.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:

Fig. 1    eine schematische Darstellung eines erfindungsgemäßen Raumüberwachungsgeräts in Form eines Blockschaltbildes;

Fig. 2    eine vergrößerte exemplarische Darstellung eines Beobachtungsraumwinkels eines Empfängers, eines Raumwinkels eines Senders und eines Beobachtungsraums und einer Beobachtungsfläche;

Fig. 3    einen Schnitt durch eine Ausführungsform eines Senders kombiniert mit einem Empfänger;

Fig. 4    einen Schnitt längs Linie 4-4 in Fig. 3;

| Fig. 5 | eine schematische Darstellung einer weiteren Variante eines Senders kombiniert mit einem Empfänger ähnlich Fig. 3; |
| Fig. 6 | einen Schnitt Längs Linie 6-6 in Fig. 5; |
| Fig. 7 | eine insbesondere für Kraftfahrzeuge modifizierte Ausführungsform eines erfindungsgemäßen Raumüberwachungsgeräts; |
| Fig. 8 | eine schematische Darstellung von möglichen empfangenen Beobachtungssignalen im Fall eines Eingriffs in einen Beobachtungsraum; |
| Fig. 9 | eine exemplarische Darstellung einer Auswertung eines senderaktiven Beobachtungssignals und |
| Fig. 10 | eine schematische Darstellung eines pulsweitenmodulierten Beobachtungssignals. |

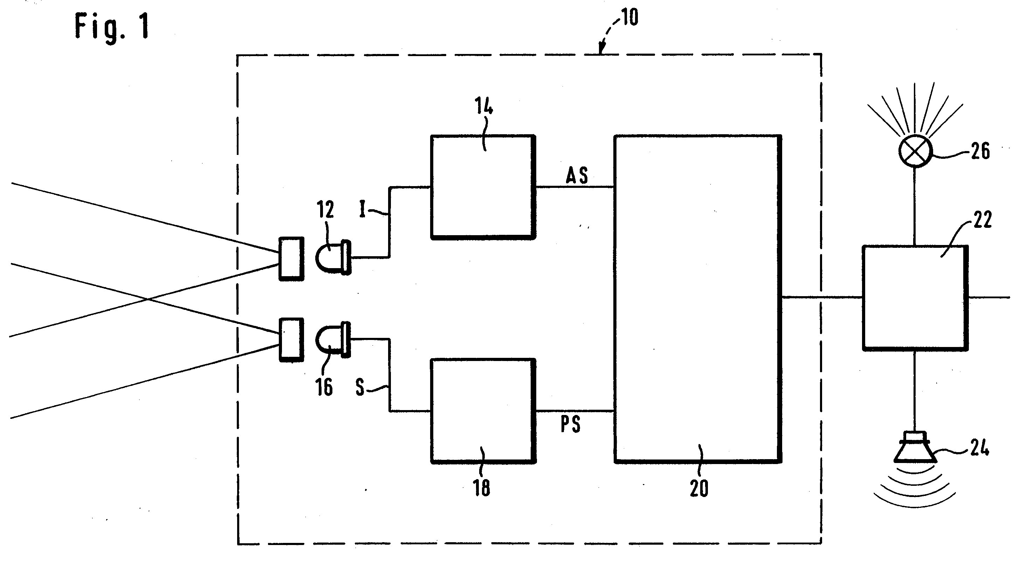

Ein Ausführungsbeispiel eines erfindungsgemäßen als Ganzes mit 10 bezeichneten Raumüberwachungsgerätes umfaßt, wie in Fig. 1 dargestellt, einen Sender 12, für elektromagnetische Strahlung, vorzugsweise Infrarotstrahlung, welcher beispielsweise als Infrarotdiode ausgebildet ist. Dieser Sender 12 wird durch eine Leistungsansteuerung 14 betrieben, welche den Sender 12 mit einem die Sendeleistung desselben bestimmenden Strom I speist.

Ferner umfaßt das erfindungsgemäße Raumüberwachungsgerät 10 einen Empfänger 16, welcher Infrarotstrahlung empfängt und entsprechend der Intensität der empfangenen Infrarotstrahlung ein Beobachtungssignal S erzeugt, welches über einen Umsetzer 18 einer Überwachungsschaltung 20 übermittelt wird, die ihrerseits mit einer Alarmanlage 22 korrespondiert. Die Alarmanlage 22 arbeitet in konventioneller Weise, gibt beispielsweise im Fall eines Eingriffs in den durch das Raumüberwachungsgerät 10 überwachten Raum über einen akustischen Melder 24 akustische Signale oder einen optischen Melder 26 optische Signale ab und führt im übrigen noch weitere Funktionen in bekannter Art und Weise aus.

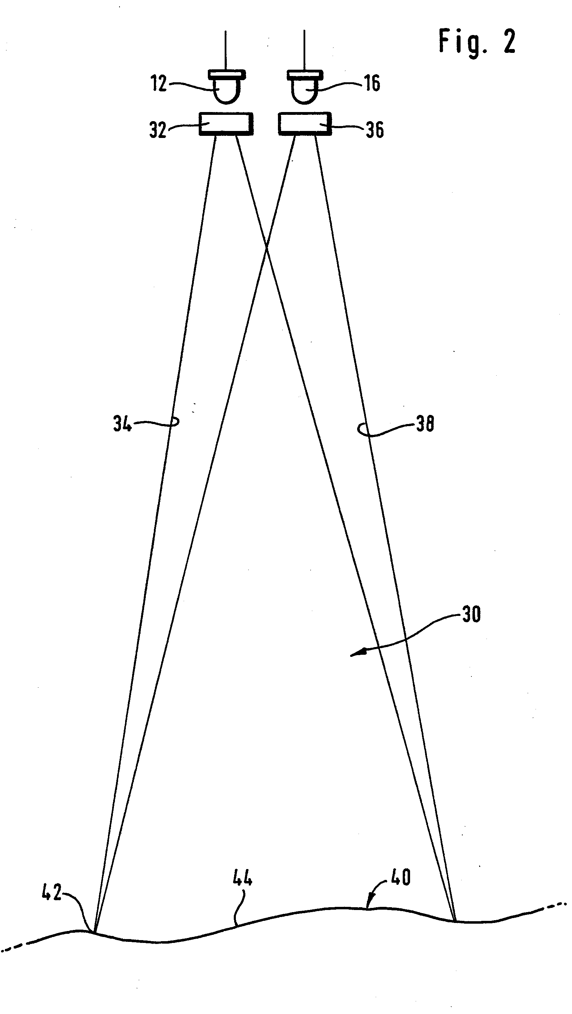

Zur genauen Überwachung eines in Fig. 2 mit 30 bezeichneten Raums ist der Sender 12 mit einer richtungsbestimmenden Optik 32 versehen, welche die vom Sender 12 erzeugte elektromagnetische Strahlung über eine Raumwinkel 34 verteilt, jedoch auf diesen beschränkt aussendet.

In gleicher Weise ist der Empfänger 16 mit einer richtungsgebenden Optik 36 versehen, welche innerhalb eines Raumwinkels 38 sich in Richtung des Empfängers 16 ausbreitende elektromagnetische Strahlung auf dem Empfänger 16 auftreffen läßt.

Die vom Sender 12 emittierte elektromagnetische Strahlung, in diesem Fall vorzugsweise die vom Sender 12 emittierte Infrarotstrahlung, wird durch die richtungsgebende Optik 32 innerhalb des Raumwinkels 34 und über diesen verteilt, vorzugsweise im wesentlichen gleichmäßig verteilt abgestrahlt, so daß eine äußere Grenzfläche des Raumwinkels 34 den von Infrarotstrahlung durchsetzten Raum 30 umschließt.

Der Raumwinkel 34 ist so ausgerichtet, daß er eine Fläche 40 im Bereich einer Umrißlinie 42 schneidet und somit eine innerhalb der Umrißlinie liegende Beobachtungsfläche 44 festlegt, welche aufgrund ihrer Ausleuchtung durch den Sender 12 Infrarotstrahlung reflektiert.

Der Raumwinkel 38 ist vorzugsweise so ausgerichtet, daß dieser entweder die ganze Beobachtungsfläche 44 oder einen Teil derselben erfaßt, jedoch im wesentlichen nicht über die Beobachtungsfläche 44 hinaus reicht, sondern vorzugsweise ausschließlich Bereiche der Beobachtungsfläche 44 erfaßt. Im Idealfall bildet der Schnitt des Raumwinkels 38 mit der Fläche 40 ebenfalls die Umrißlinien 42 der Beobachtungsfläche 44, so daß der Empfänger 16 das gesamte von der Beobachtungsfläche 44 reflektierte Infrarotlicht des Senders 12 zu empfangen in der Lage ist. Hierzu wird die richtungsgebende Optik 36 entsprechend ausgebildet.

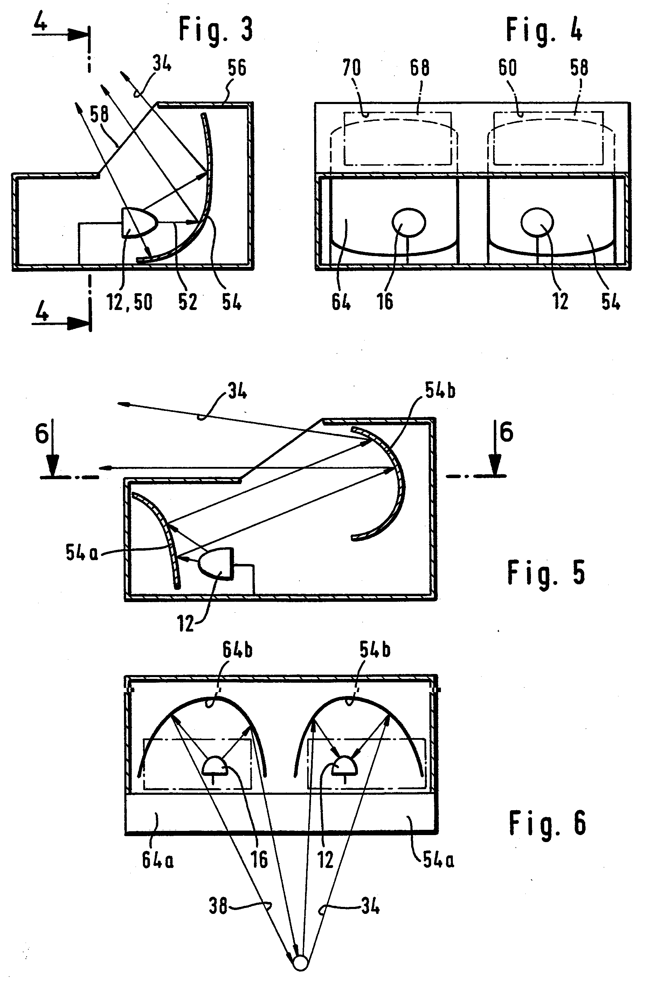

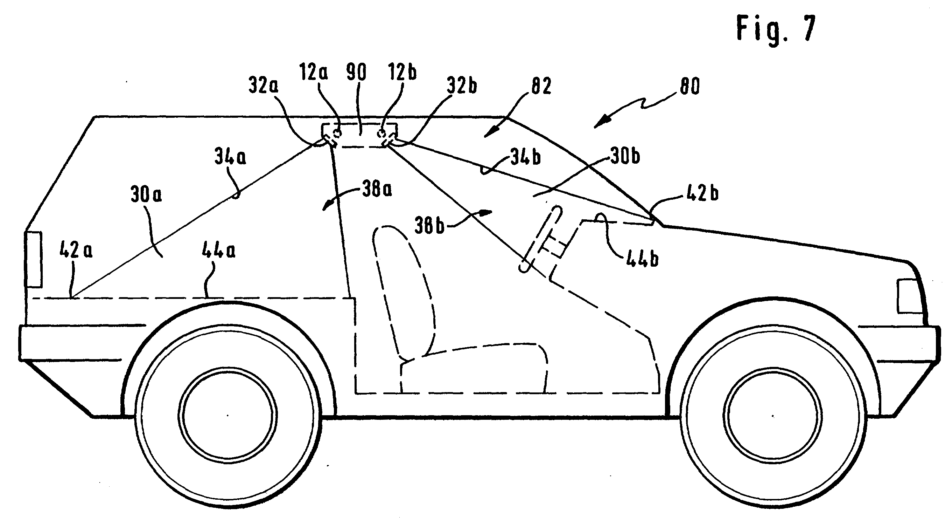

Ein Beispiel einer erfindungsgemäßen Anordnung des Senders 12 ist in Fig. 3 und 4 dargestellt.

Der Sender 12, in diesem Fall eine Infrarotleuchtdiode 50, sendet Infrarotstrahlung 52 aus, welche auf einen konkav geformten Reflektor 54 trifft, der dann die Infrarotstrahlung in den Raumwinkel 34 hineinreflektiert.

Der Reflektor 54 sitzt dabei in einem als Ganzes mit 56 bezeichneten Gehäuse und reflektiert die Infrarotstrahlung 52 so, daß diese mit dem gewünschten Raumwinkel 34 aus einem Fenster 58 des Gehäuses austritt.

Sowohl der Reflektor 54 als auch das Fenster 58 sind so ausgebildet, daß sie den gewünschten Raumwinkel 34 genau festlegen, welcher nicht nur eine konische Form zu haben braucht, sondern jede Art von Form aufweisen kann, und zwar entsprechend der gewünschten und auszuleuchtenden Beobachtungsfläche 44.

Im einfachsten Fall läßt sich der Raumwinkel 34 dadurch hinsichtlich seiner äußeren Begrenzung definieren, daß Seitenkanten 60 des Fensters 58 hinsichtlich ihrer relativen Lage zum Reflektor 54 und Sender 12 einstellbar sind, so daß das Fenster 58 mit seinen Seitenkanten 60 gleichzeitig auch als Blende wirkt, mit welcher der Raumwinkel 34 einstellbar ist.

Bei besonders schwierig auszuleuchtenden Beobachtungsflächen ist es auch noch ebenfalls denkbar, das Fenster 58 auch als Linse zu formen, um somit noch besondere Ausformungen des Raumwinkels 34 zu erhalten.

Vorzugsweise ist, bezogen auf einen Querschnitt des Raumwinkels die Intensität der elektromagnetischen Strahlung pro Querschnittsfläche ungefähr gleich groß.

In gleicher Weise ist der in dem Gehäuse 56 angeordnete Empfänger 16 ebenfalls mit der richtungsgebenden Optik 36 versehen, die den Raumwinkel 38 definiert. Der Raumwinkel 38 wird dabei durch die Form des Reflektors 64 und das Fenster 68 definiert, wobei das Fenster 68 ebenfalls variabel einstellbare Seitenkanten 70 aufweist, welche relativ zum Empfänger 16 einstellbar an dem Gehäuse 56 angeordnet sind, um mittels einer Blendenwirkung den Raumwinkel 38 exakt zu definieren. Im Zusammenhang mit der Einstellung des Raumwinkels 38 ist aufgrund des in ähnlicher Weise ausgebildeten Reflektors 64 und des Fensters 68 auf die Ausführungen zur richtungsgebenden Optik 34 für den Sender 12 zu verweisen.

Besonders vorteilhaft ist die erfindungsgemäße Lösung, wie in Fig. 4 dargestellt, dadurch, daß der Sender 12 und der Empfänger 16 nahe beieinander in einem einzigen Gehäuse 56 angeordnet sind und somit nahe beieinander liegen, um zu erreichen, daß der Raumwinkel 38 im wesentlichen deckungsgleich mit dem Raumwinkel 34 oder innerhalb desselben verläuft.

Bei einer Variante ist, wie in Fig. 5 und 6 dargestellt, der Reflektor 54 durch einen konvexen Reflektor 54a und einen konkaven Reflektor 54b ersetzt, welche eine derartige Anordnung des Senders 12 erlauben, daß dieser selbst keine Abschattungen mehr bewirkt. Das gleiche gilt für den Empfänger 16, und die diesem zugeordnete richtungsgebende Optik 36, wie aus Fig. 6 erkennbar ist.

Beispielsweise wird ein derartiges erfindungsgemäßes Raumüberwachungsgerät in einem als Ganzes mit 80 bezeichneten Kraftfahrzeug zur Überwachung eines Innenraums 82 eingesetzt, wobei in dem Innenraum 82 gezielte Beobachtungsflächen 44a und 44b festgelegt und von dem jeweiligen Raumwinkel 34a bzw. 34b erfaßbar angeordnet sind.

In gleicher Weise ist der Raumwinkel 38 so angeordnet, daß dieser im wesentlichen deckungsgleich zum Raumwinkel 34 liegt und insbesondere auch eine Umrißlinie 42a bzw. 42b der Beobachtungsflächen 44a bzw. 44b von beiden Raumwinkeln 34a bzw. 34b und 38a bzw. 38b erfaßt wird.

Vorzugsweise ist dies durch ein erfindungsgemäßes Raumüberwachungsgerät 90 realisiert, welches mehrere Sender 12a bzw. 12b aufweist, die mit unterschiedlicher richtungsgebender Optik 32a bzw. 32b die Raumwinkel 34a bzw. 34b und somit auch die Beobachtungsfläche 44a bzw. 44b mit der entsprechenden Umrißlinie 42a bzw. 42b festlegen.

Beispielsweise ist im Fall des Kraftfahrzeugs 80 die Beobachtungsfläche 44a so gelegt, daß sie beispielsweise einer Bodenfläche eines hinteren Gepäckraums entspricht, während die Beobachtungsfläche 44b so liegt, daß sie entweder das gesamte Armaturenbrett oder zumindest mit wesentlichen Bedienungselemente versehene Teile desselben umfaßt.

Ferner ist das Raumüberwachungsgerät 90 noch mit ebenfalls den Sendern 12a und 12b entsprechenden Empfängern versehen, die außerdem über geeignete richtungsgebende Optiken in dem jeweiligen Raumwinkel 38a und 38b Infrarotstrahlung empfangen, welcher die Beobachtungsflächen 44a bzw. 44b entweder ganz oder teilweise umfaßt. Das erfindungsgemäße Überwachungsgerät weist jedoch vorzugsweise lediglich eine Überwachungsschaltung 20 auf, die abwechslungsweise entweder den Beobachtungsraum 30a oder den Beobachtungsraum 30b in bereits beschriebener Art und Weise überwacht.

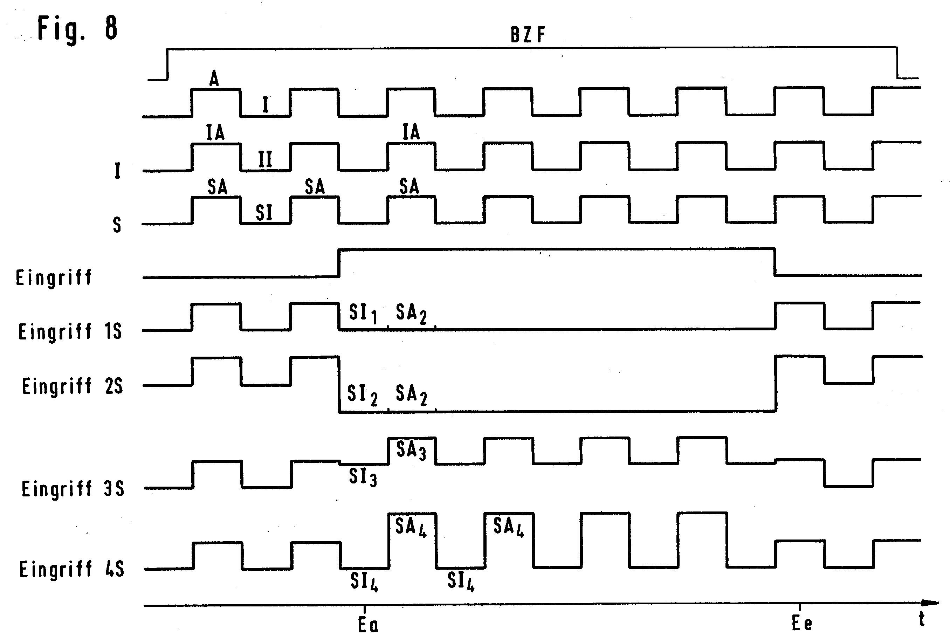

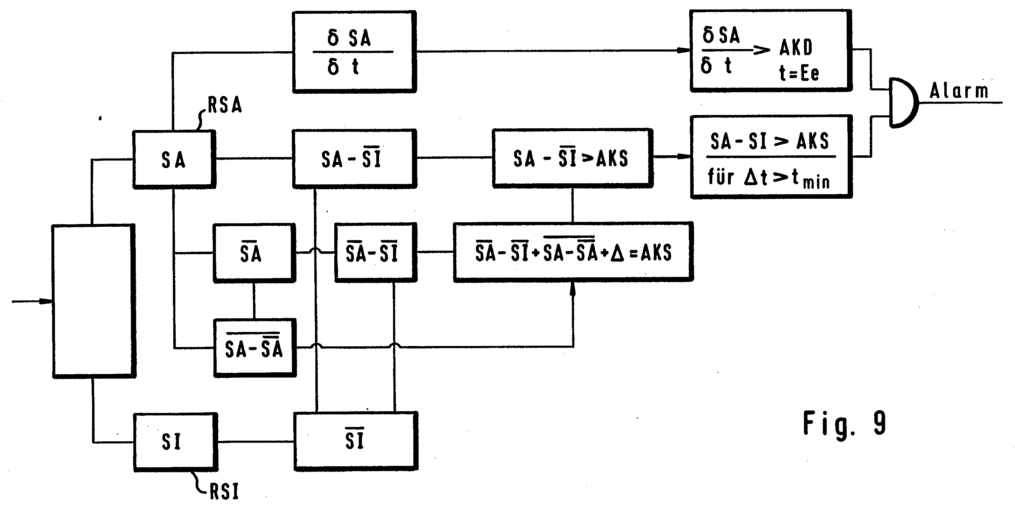

Die Überwachungsschaltung 20 arbeitet bei allen vorstehenden Ausführungsformen vorzugsweise so, daß für sie, wie in Fig. 8 dargestellt, innerhalb eines Beobachtungszeitfensters BZF den Strom I für den Sender ein- und ausschaltet, so daß der Sender 12 während eines senderaktiven Zeitraums A mit dem Strom IA beaufschlagt wird und während eines senderinaktiven Zeitraums I mit dem Strom II, wobei der Strom II im einfachsten Fall Null jedoch auch von Null verschieden sein kann.

Damit verhält sich - ohne daß ein Eingriff in den Beobachtungsraum 30 erfolgt - das Beobachtungssignal S, welches der Empfänger 16 empfängt aufgrund der Reflexion der vom Sender 12 kommenden Infrarotstrahlung an der Beobachtungsfläche 44 in gleicher Weise wie der Strom I, mit dem der Sender beaufschlagt wird, das heißt während des senderaktiven Zeitraums A wird das senderaktive Beobachtungssignal SA gemessen, während während des senderinaktiven Zeitraums I das senderinaktive Beobachtungssignal SI erfaßt wird. Das heißt, daß im Idealfall ohne Eingriff in den Beobachtungsraum 30 das Zeitverhalten des Beobachtungssignal S genau dem Zeitverhalten des den Sender 12 speisenden Stroms I entspricht.

Erfolgt nun in den Beobachtungsraum 30 ein Eingriff vom Zeitpunkt Ea bis zum Zeitpunkt Ee, so kann dieser sich in unterschiedlichster Art und Weise auf das Beobachtungssignal S auswirken.

So ist es beispielsweise bei einem in Fig. 8 als Eingriff 1 bezeichneten Fall denkbar, daß sich ein Körper in den Raum 30 hineinbewegt und dadurch zumindest eine Abschattung der von der Beobachtungsfläche 44 in Richtung des Empfängers 16 reflektierten Infrarotstrahlung des Senders 12 führt, so daß während einer Anzahl von senderaktiven Zeiträumen A das Beobachtungssignal S nicht mehr das senderaktive Beobachtungssignal SA zeigt, sondern lediglich ein ungefähr dem senderinaktiven Beobachtungssignal $SI_1$ entsprechendes Signal $SA_1$, das heißt, daß in diesem Fall das Beobachtungssignal S nicht mehr das dem den Sender 12 beaufschlagenden Strom I entsprechende Zeitverhalten zeigt.

Die Abschattung durch einen in den Beobachtungsraum 30 eindringenden Körper kann sogar zur Folge haben, daß, wie noch extremer im Fall Eingriff 2 dargestellt, der Empfänger 16 eine Intensität der aus dem Beobachtungsraumwinkel 38 empfangenen Infrarotstrahlung beobachtet und somit Beobachtungssignale $SA_2$ und Beobachtungssignale $SI_2$, welche kleiner sind als das üblicherweise beobachtete senderinaktive Beobachtungssignal SI.

Es ist aber auch denkbar, wie im Fall des Eingriffs 3 in Fig. 8 dargestellt, daß der in den Beobachtungsraum 30 eindringende Körper auch während der senderinaktiven Zeiträume I mehr Infrarotstrahlung in den Beobachtungsraumwinkel 38 hineinreflektiert und außerdem die vom Sender 12 kommende Infrarotstrahlung noch stärker reflektiert, so daß das Beobachtungssignal S während des Eingriffs sowohl als senderinaktives Beobachtungssignal $SI_3$ als auch als senderaktives Beobachtungssignal $SA_3$ höhere Intensitäten zeigt als im Fall ohne Eingriff.

Ferner ist es, wie in Fig. 8 für den Fall des Eingriffs 4 angegeben, denkbar, daß bei in den Raum 30 eindringendem Körper die senderaktiven Beobachtungssignale $SA_4$ größer sind als im Fall des nichteindringenden Körpers, die senderinaktiven Beobachtungssignale $SI_4$ jedoch ungefähr denen ohne eingedrungenen Körper entsprechen.

Um die anhand der Fig. 8 exemplarisch dargestellten unterschiedlichen Auswirkungen eines Eingriffs auf das Beobachtungssignal jeweils als solchen zu erkennen, speichert die erfindungsgemäße Überwachungsschaltung 20 sämtliche im Beobachtungszeitfenster BZF erfaßten senderaktiven Beobachtungssignale SA sequentiell in einem Register RSA und sämtliche senderinaktiven Beobachtungssignale SI sequentiell in einem Register RSI.

Aus den sämtlichen, während des Beobachtungszeitfensters BZF in dem Register RSA abgelegten senderaktiven Beobachtungssignalen SA ermittelt die Überwachungsschaltung 20 einen Mittelwert $\overline{SA}$.

Ferner ermittelt die Überwachungsschaltung 20 die mittlere quadratische Abweichung aller innerhalb des Beobachtungszeitfensters BZF erfaßten Beobachtungssignale SA vom Mittelwert $\overline{SI}$ ü.

Ferner ermittelt die Überwachungsschaltung 20 aus sämtlichen im Register RSI während des Beobachtungszeitfensters BZF abgelegten senderinaktiven Beobachtungssignalen SI den Mittelwert $\overline{SI}$.

Um ferner die Beobachtungssignale SA hinsichtlich Langzeitdrifterscheinungen sowohl der in den Beobachtungsraumwinkel eintretenden elektromagnetischen Strahlung als auch der elektronischen Komponenten zu korrigieren, wird der Mittelwert $\overline{SI}$ von den senderaktiven Beobachtungssignalen abgezogen und anschließend wird in einer weiteren Stufe geprüft, ob der hinsichtlich Langzeitdrifterscheinungen korrigierte Wert der senderaktiven Beobachtungssignale $SA-\overline{SI}$ größer ist als eine ein Alarmkriterium darstellende Schwelle AKS.

Der Wert der Schwelle AKS wird bestimmt einerseits durch den ebenfalls hinsichtlich des Mittelwerts $\overline{SI}$ der senderinaktiven Beobachtungssignale korrigierten Mittelwerts $\overline{SA}$ der senderaktiven Beobachtungssignale

SA und zu diesem Mittelwert wird die bereits ermittelte mittlere quadratische Abweichung $SA-\overline{SA}$ der senderaktiven Beobachtungssignale SA hinzuaddiert und um sicherzustellen, daß die Schwelle AKS außerhalb des mittleren quadratischen Abweichung liegt, noch ein $\delta$.

Sind einige der hinsichtlich der Langzeitdrift korrigierten senderaktiven Beobachtungssignale $SA-\overline{SI}$ größer als die Schwelle AKS, so wird ferner von der Überwachungsschaltung 20 geprüft, ob dies für einen Zeitraum zutrifft, der größer als eine minimale Zeitspanne ist, die als weiteres Alarmkriterium der Überwachungsschaltung 20 vorgegeben ist. Diese minimale Zeitspanne wird so angesetzt, daß sie größer ist als minimale Störungen, die beispielsweise durch eine den Beobachtungsraum durchfliegende Fliege verursacht werden können.

Parallel wird noch die zeitliche Entwicklung der senderaktiven Beobachtungssignale SA hinsichtlich der Zeit differenziert, das heißt alle im Register RSA aufeinanderfolgend abgespeicherten senderaktiven Beobachtungssignale SA stellen ein eine zeitliche Entwicklung dar und bezüglich der Zeit wird durch Differenzieren die Ableitung gebildet.

Das differenzierte Signal stellt ein Maß für sich ergebende signifikante Änderungen dar und es wird dabei geprüft, ob diese signifikanten Änderungen zu Zeitpunkten erfolgen, zu denen auch die hinsichtlich der Langzeitdrift korrigierten senderaktiven Beobachtungssignale über der Schwelle AKS liegen. Ist dies der Fall, so wird ein Alarm erzeugt.

Diese für einen Fall dargestellte exemplarische Auswertung der senderaktiven Beobachtungssignale kann noch erweitert werden, dadurch daß zwei gegebenenfalls unterschiedliche Schwellwerte AKS, nämlich ein oberer Schwellwert und ein unterer Schwellwert für die senderaktiven Beobachtungssignale als Alarmkriterium überprüft werden.

Ferner ist es denkbar, in gleicher Weise Überprüfung hinsichtlich der senderinaktiven Beobachtungssignale durchzuführen.

Schließlich ist es im Rahmen einer weiteren verfeinerten Auswertung noch möglich, die im Rahmen aufeinanderfolgender Beobachtungszeitfenster gewonnenen Größen zueinander in Relation zu setzen, um Langzeitdrifts, beispielsweise sich verändernde Sonneneinstrahlung etc. zu erfassen und berichtigen zu können.

Ferner sieht ein vorteilhaftes Ausführungsbeispiel vor, daß stets nach Einschalten der erfindungsgemäßen Raumüberwachungseinrichtung davon ausgegangen werden kann, daß unmittelbar nach dem Einschalten keine Störung des Raums erfolgt und daher die in diesem Zeitraum gemessenen senderaktiven Beobachtungssignale SA und senderinaktiven Beobachtungssignale SI störungsfreie Beobachtungssignale darstellen, anhand derer Kriterien für die Schaltsicherheit und Störungssicherheit bestimmbar sind.

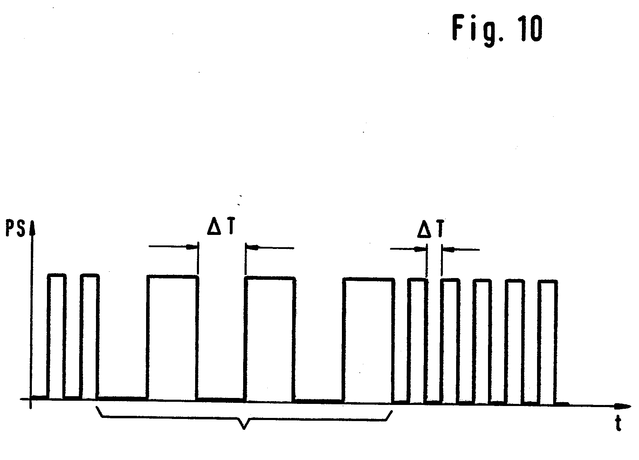

Eine hinsichtlich der Auswertbarkeit durch die Auswerteschaltung 20 besonders günstige Lösung sieht vor, daß der Umsetzer 18 als spannungsgesteuerter Oszillator ausgebildet ist und somit, wie in Fig. 10 dargestellt, ein dem Beobachtungssignal S entsprechendes pulsweitenmoduliertes Signal PS mit konstantem Pegel, jedoch mit variierender Frequenz liefert. Dabei entsprechen in großen Abständen ΔT aufeinanderfolgende Impulse einer niedrigen Frequenz und somit einer kleinen gemessenen Intensität der Infrarotstrahlung entsprechen, während in kurzen Zeitabständen aufeinanderfolgende Impulse einer großen Frequenz und somit auch einer großen Intensität der Infrarotstrahlung entsprechen.

Ein derartiges pulsweitenmoduliertes Signal PS läßt sich besonders einfach dadurch analysieren, daß die Zeiten aufeinanderfolgender Flankenwechsel, beispielsweise unter Zuhilfenahme eines Taktgenerators, gemessen und aufeinanderfolgend in einem Register abgelegt werden. Dabei werden vorzugsweise innerhalb eines der senderaktiven Zeitintervalle A oder der senderinaktiven Zeitintervalle I die Zeiträumen zwischen einer Vielzahl von jeweils aufeinanderfolgenden Flankenwechseln erfaßt.

Ein pulsweitenmoduliertes Signal hat ferner noch den Vorteil, daß in einfacher Art und Weise ein Differenzieren der Meßwerte möglich ist, da bei Vorliegen der Zeitabstände aufeinanderfolgender Flankenwechsel eine Differenzbildung zwischen den aufeinanderfolgenden Werten für die Zeitabstände das differenzierte Signal liefert.

Vorzugsweise liegen bei einer erfindungsgemäßen Lösung die Frequenzen der Pulsfolge zwischen ungefähr 1 Hz und ungefähr 300 kHz, während die senderaktiven Zeiträume und die senderinaktiven Zeiträume in der Größenordnung von ungefähr 50 msec. bis ungefähr 150 msec. und das Beobachtungszeitfenster in der Größenordnung von mehreren hundert msec. liegt.

**Patentansprüche**

1. Raumüberwachungsgerät umfassend einen Empfänger für elektromagnetische Strahlung und eine ein Beobachtungssignal des Empfängers im Hinblick auf ein Alarmkriterium überprüfende Überwachungsschaltung,
**dadurch gekennzeichnet**, daß der Empfänger (16) aus einem genau bestimmten Beobachtungsraum (30), definiert durch einen fest vorgegebenen Beobachtungsraumwinkel (38) und eine hinsichtlich ihrer Umrißlinie (42) durch den Beobachtungsraumwinkel (38) bestimmte Beobachtungsfläche (44), die Intensität der elektromagnetischen Strahlung integral erfaßt und ein der integralen Intensität entsprechendes Beobachtungssignal (S) erzeugt, daß ein Sender (12) vorgesehen ist, der zur Ausleuchtung der Beobachtungsfläche (44) elektromagnetische Strahlung aussendet und daß die Überwachungsschaltung (20) während eines senderaktiven Zeitraums (A) ein senderaktives Beobachtungssignal (SA) und während eines senderinaktiven Zeitraums (I) ein senderinaktives Beobachtungssignal (SI) erfaßt und sowohl das senderaktive Beobachtungssignal (SA) als auch das senderinaktive Beobachtungssignal (SI) bei der Entscheidung hinsichtlich der Erfüllung oder Nichterfüllung des Alarmkriteriums (AK) berücksichtigt.

2. Raumüberwachungsgerät nach Anspruch 1, dadurch gekennzeichnet, daß der Sender (12) die Beobachtungsfläche (44) im wesentlichen voll ausleuchtet.

3. Raumüberwachungsgerät nach Anspruch 2, dadurch gekennzeichnet, daß der Sender (12) in einen derartigen Raumwinkel (34) abstrahlt, daß die abgestrahlte elektromagnetische Strahlung im wesentlichen auf die Beobachtungsfläche (44) begrenzt ist.

4. Raumüberwachungsgerät nach einem der voranstehenden Ansprüche, dadurch gekennzeichnet, daß der Sender (12) die elektromagnetische Strahlung in einen Raumwinkel (34) abstrahlt, welcher überwiegend mit dem Beobachtungsraumwinkel (38) überlappt.

5. Raumüberwachungsgerät nach einem der voranstehenden Ansprüche, dadurch gekennzeichnet, daß der Sender (12) und der Empfänger (16) nebeneinander in einem Gehäuse (56) angeordnet und auf dieselbe Beobachtungsfläche (44) gerichtet sind.

6. Raumüberwachungsgerät nach einem der voranstehenden Ansprüche, dadurch gekennzeichnet, daß dieses mehrere, genau bestimmte Beobachtungsräume (38a, 38b) überwacht und daß jedem Beobachtungsraum (38a, 38b) mindestens ein Empfänger (16a, 16b) zugeordnet ist.

7. Raumüberwachungsgerät nach Anspruch 6, dadurch gekennzeichnet, daß dieses eine einzige Überwachungsschaltung (20) für die Ermittlung der Alarmkriterien für die einzelnen Beobachtungsräume (30a, 30b) aufweist.

8. Raumüberwachungsgerät nach Anspruch 7, dadurch gekennzeichnet, daß die Überwachungsschaltung (20) die Alarmkriterien (AK) für die einzelnen Beobachtungsräume (30a, 30b) nacheinander prüft.

9. Raumüberwachungsgerät nach einem der voranstehenden Ansprüche, dadurch gekennzeichnet, daß dem Empfänger (16) eine richtungsgebende Optik (36, 54, 60) zugeordnet ist.

10. Raumüberwachungsgerät nach Anspruch 9, dadurch gekennzeichnet, daß die richtungsgebende Optik (36, 54, 60) in dem Gehäuse (56) für den Empfänger (16) angeordnet ist.

11. Raumüberwachungsgerät nach Anspruch 10, dadurch gekennzeichnet, daß die richtungsgebende Optik (36, 54, 60) ein vom Empfänger (16) getrenntes Bauteil ist.

12. Raumüberwachungsgerät nach einem der voranstehenden Ansprüche, dadurch gekennzeichnet, daß dem Sender (12) eine richtungsgebende Optik (32, 64, 68) zugeordnet ist.

13. Raumüberwachungsgerät nach Anspruch 12, dadurch gekennzeichnet, daß die richtungsgebende Optik (32, 64, 68) in dem Gehäuse (56) für den Sender (12) angeordnet ist.

14. Raumüberwachungsgerät nach Anspruch 12 oder 13, dadurch gekennzeichnet, daß die richtungsgebende Optik (32, 64, 68) ein vom Sender (12) separates Bauteil darstellt.

15. Raumüberwachungsgerät nach einem der Ansprüche 9 bis 14, dadurch gekennzeichnet, daß die richtungsgebende Optik (32; 36; 54; 58; 64, 68) strahlformende Elemente (54, 58; 64, 68) umfaßt.

16. Raumüberwachungsgerät nach einem der voranstehenden Ansprüche, dadurch gekennzeichnet, daß die Überwachungsschaltung (20) ständig zwischen senderaktiven (A) und senderinaktiven Zeiträumen (I) wechselt.

17. Raumüberwachungsgerät nach Anspruch 16, dadurch gekennzeichnet, daß die senderaktiven Zeiträume (A) und die senderinaktiven Zeiträume (I) in derselben Größenordnung liegen.

18. Raumüberwachungsgerät nach einem der voranstehenden Ansprüche, dadurch gekennzeichnet, daß die Überwachungsschaltung (20) bei der Anwendung des Alarmkriteriums (AK) zwischen senderaktiven Beobachtungssignalen (SA) und senderinaktiven Beobachtungssignalen (SI) unterscheidet.

19. Raumüberwachungsgerät nach Anspruch 18, dadurch gekennzeichnet, daß die Überwachungsschaltung (20) bei Anwendung des Alarmkriteriums (AK) auf eines der Beobachtungssignale (SA) das jeweils andere Beobachtungssignal (SI) ebenfalls berücksichtigt.

20. Raumüberwachungsgerät nach Anspruch 19, dadurch gekennzeichnet, daß die Überwachungsschaltung (20) das jeweilige Beobachtungssignal (SA) im Hinblick auf ein Überschreiten einer das Alarmkriterium darstellenden Schwelle (AKS) überprüft.

21. Raumüberwachungsgerät nach Anspruch 20, dadurch gekennzeichnet, daß die Überwachungsschaltung (20) die Schwelle (AKS) unter Heranziehung des jeweils anderen Beobachtungssignals (SI) ermittelt.

22. Raumüberwachungsgerät nach Anspruch 20 oder 21, dadurch gekennzeichnet, daß die Überwachungsschaltung (20) bei Ermittlung der Schwelle (AKS) die zeitliche Entwicklung des jeweils zu prüfenden Beobachtungssignals (SA) ermittelt.

23. Raumüberwachungsgerät nach Anspruch 22, dadurch gekennzeichnet, daß die Überwachungsschaltung (20) bei der Festlegung der Schwelle (AKS) ein aus den jeweils zu prüfenden Beobachtungssignalen (SA) gemitteltes Signal ($\overline{SA}$) heranzieht.

24. Raumüberwachungsgerät nach einem der Ansprüche 20 bis 23, dadurch gekennzeichnet, daß die Überwachungsschaltung (20) bei der Festlegung der Schwelle (AKS) eine Streuung der jeweils zu prüfenden Beobachtungssignale (SA) um das gemittelte Beobachtungssignal ($\overline{SA}$) ermittelt.

25. Raumüberwachungsgerät nach Anspruch 23, dadurch gekennzeichnet, daß die Schwelle (AKS) außerhalb einer mittleren Streubandbreite (SA-$\overline{SA}$) des jeweils zu prüfenden Beobachtungssignals (SA) gesetzt wird.

26. Raumüberwachungsgerät nach einem der voranstehenden Ansprüche, dadurch gekennzeichnet, daß die Überwachungsschaltung (20) zur Analyse des jeweiligen Beobachtungssignals (SA) ein eine Vielzahl von senderaktiven (A) und senderinaktiven Zeiträumen (I) umfassendes Beobachtungszeitfenster (BZF) heranzieht.

27. Raumüberwachungsgerät nach einem der voranstehenden Ansprüche, dadurch gekennzeichnet, daß die Überwachungsschaltung (20) die jeweils zu überprüfenden Beobachtungssignale (SA) entsprechend dem Langzeitverhalten korrigiert.

28. Raumüberwachungsgerät nach einem der Ansprüche 18 bis 27, dadurch gekennzeichnet, daß die Überwachungsschaltung (20) das sich zeitlich entwickelnde jeweilige Beobachtungssignal (SA, SI) nach der Zeit differenziert.

29. Raumüberwachungsgerät nach einem der Ansprüche 18 bis 28, dadurch gekennzeichnet, daß die Überwachungsschaltung (20) die Dauer der Überschreitung einer Schwelle (AKS) prüft und erst bei Überschreiten der Schwelle (AKS) während einer Mindestdauer das Alarmkriterium als erfüllt ansieht.

30. Raumüberwachungsgerät nach einem der voranstehenden Ansprüche, dadurch gekennzeichnet, daß das vom Empfänger generierte Beobachtungssignal (S) von einem Umsetzer (18) in ein mit der erfaßten Intensität entsprechenden Frequenz moduliertes Signal (PS) umsetzbar ist.

31. Raumüberwachungsgerät nach Anspruch 30, dadurch gekennzeichnet, daß das Beobachtungssignal ein pulsweitenmoduliertes Signal (PS) ist.

32. Raumüberwachungsgerät nach Anspruch 31, dadurch gekennzeichnet, daß die Überwachungsschaltung (20) die zeitabstände ($\Delta$T) zwischen wechselnden Flanken des pulsweitenmodulierten Signals (PS) erfaßt und diese Zeitabstände ($\Delta$T) als Beobachtungssignal heranzieht.

# Fig. 1

Fig. 2

Fig. 3

Fig. 4

Fig. 5

Fig. 6

Fig. 7

EP 0 865 012 A2

Fig. 8

BZF

A I
IA II
SA SI
SI SA IA
SA SA SI
I
S

Eingriff

Eingriff 1S    $SI_1$  $SA_2$

Eingriff 2S    $SI_2$  $SA_2$

Eingriff 3S    $SI_3$  $SA_3$

Eingriff 4S    $SI_4$  $SA_4$  $SI_4$  $SA_4$

Ea    Ee    t

EP 0 865 012 A2

$$\frac{\delta \, SA}{\delta \, t}$$

$$\frac{\delta \, SA}{\delta \, t} \rightarrow AKD \quad t=Ee$$

Alarm

RSA

SA

$SA - \overline{SI}$

$SA - \overline{SI} > AKS$

$$\frac{SA - SI > AKS}{\text{für } \Delta t > t_{min}}$$

$\overline{SA}$

$\overline{SA} - \overline{SI}$

$\overline{SA} - \overline{SI} + \overline{SA - \overline{SA}} + \Delta = AKS$

$\overline{SA - \overline{SA}}$

SI

$\overline{SI}$

RSI

Fig. 9

Fig. 10